# EUROPEAN PATENT SPECIFICATION

(11) **EP 4 354 199 B1**
(45) Date of publication and mention of the grant of the patent: **08.04.2026**
(21) Application number: 22841877.8
(22) Date of filing: 20.06.2022
(51) Int. Cl.: G02B 26/10, B81B 3/00, G02B 26/08

(54) **MEMS OPTICAL DEFLECTOR AND OPTICAL SCANNING DEVICE**
OPTISCHER MEMS-ABLENKER UND OPTISCHE ABTASTVORRICHTUNG
DÉFLECTEUR OPTIQUE MEMS ET DISPOSITIF DE BALAYAGE OPTIQUE

(30) Priority: 13.07.2021 JP 2021115431
(43) Date of publication of application: 17.04.2024
(73) Proprietor: STANLEY ELECTRIC CO., LTD., Tokyo 153-8636 (JP)
(72) Inventor: NAKAMURA, Susumu, Tokyo 153-8636 (JP)
(74) Representative: Pritzlaff, Stefanie Lydia
(86) International application number: PCT/JP2022/024558
(87) International publication number: WO 2023/286533

(56) References cited:
- JP-A- 2008 111 882
- JP-A- 2008 111 882
- JP-A- 2008 145 839
- JP-A- 2008 145 839
- JP-A- 2020 201 308
- US-A1- 2018 149 859
- US-A1- 2019 285 876

## Description

### Technical Field

The present invention relates to a MEMS optical deflector and an optical scanning device including a MEMS optical deflector.

### Background Art

A MEMS optical deflector is known in which a mirror portion is supported by a pair of torsion bars extending along a rotation axis, the torsion bars are twisted and vibrated around the rotation axis, and the mirror portion is reciprocated around the rotation axis at a resonance frequency (example: JP 2008-70863 A and JP 2008-116668 A).

In the MEMS optical deflector, the resonance frequency generally varies within a certain range including a design value due to manufacturing variation or the like.

In the MEMS optical deflector of JP 2008-70863 A, a piezoelectric film is formed in the torsion bar in the entire extending direction thereof, and the torsion bar is expanded and contracted in the extending direction by applying a voltage to the piezoelectric film to change a rigidity of the torsion bar, and the resonance frequency of the mirror portion is adjusted.

In the MEMS optical deflector of JP 2008-116668 A, each of the torsion bars is provided with a piezoelectric element at a center position in a longitudinal direction thereof, and a voltage is applied to the piezoelectric element, so that the torsional rigidity of the torsion bar is changed and the resonance frequency of the mirror portion is adjusted.

JP 2008-111882 A discloses an actuator, optical scanner and image forming apparatus. IN order to provide an actuator which exhibits desired oscillation characteristics by changing the torsional resonance frequency of an oscillator, which is composed of a movable plate and a pair of axis members, and to provide an optical scanner and an image forming apparatus, the proposed actuator has a rigidity changing means which changes the torsional rigidity of the pair of axis members. The rigidity changing means is provided with piezoelectric elements which change the tension applied on the pair of axis members by elongation and contraction, each of the axis members is connected to a supporting part via the piezoelectric elements, respectively, and the torsional rigidity of the pair of axis members is changed by elongation and contraction of the piezoelectric elements.

JP 2008-145839 A discloses an optical scanner. In order to provide an optical scanner capable of enhancing the latitude of arrangement design with respect to a variable device for varying vibration characteristics, the proposed optical scanner includes a mirror part, torsion bars connecting to the mirror part, and a vibration exciter connecting to the torsion bars. The vibration exciter comprises first piezoelectric elements for applying vibration and second piezoelectric elements for variable spring constant for varying the spring constant (vibration characteristic) of the vibration exciter. Then, in oscillating/vibrating the mirror part by applying a driving voltage to the first piezoelectric elements, the resonance frequency of a vibration system of the optical scanner can be changed by applying a control voltage to the second piezoelectric elements. In such optical scanner, the second piezoelectric elements can be installed in the vibration exciter that has less restriction for the installation space, thereby enhancing the latitude of the arrangement design of the second piezoelectric elements.

US 2019/285876 A1 discloses an optical scanning device which includes a mirror support including a first surface and a second surface, a mirror for reflecting a laser beam being formed on the first surface; a driving beam that includes a beam extending in a direction orthogonal to a predetermined axis and is connected to the mirror support; a driving source that is formed on a surface of the beam and causes the mirror support to rotate around the predetermined axis; and a rib formed on the second surface of the mirror support at a position corresponding to the mirror. The first surface of the mirror support includes an area where the mirror is formed and an exposed area where the first surface is exposed.

### Summary of Invention

### Technical Problem

Since the torsion bar is thin and reciprocates at a high frequency, in the MEMS optical deflector of JP 2008-70863 A and JP 2008-116668 A in which a long piezoelectric film or wiring is formed on the torsion bar, it is easy to cause a problem that the piezoelectric film is peeled off, or the wiring is broken or peeled off, or the like. Further, in the torsion bar, when the piezoelectric element is provided at an intermediate point between a support point and the mirror portion, and a voltage is applied to the piezoelectric element, stress concentration easily occurs at the intermediate point thereof, and a durability of the torsion bar is lowered.

An object of the present invention is to provide a MEMS optical deflector and an optical scanning device capable of smoothly adjusting a resonance frequency of a mirror portion around a rotation axis without causing a problem in the durability of a torsion bar.

### Solution to Problem

A MEMS optical deflector of the present invention is provided as set forth in claim 1.

An optical scanning device of the present invention is provided as set forth in claim 5.

Preferred embodiments of the present invention may be gathered from the dependent claims.

### Effect of the Invention

According to the present invention, it is possible to adjust the resonance frequency of the mirror portion around the rotation axis by changing the rigidity of the support portion of the torsion bar by controlling the application of the voltage of the rigidity changing piezoelectric element of the setting region. Since the setting region where the rigidity changing piezoelectric element is formed exists in the support where appropriate dimensions are ensured, the rigidity changing piezoelectric element can be generated without causing a problem in the durability of the torsion bar.

### Brief Description of Drawings

FIG. 1 is an overall schematic view of an optical scanning device.
FIG. 2 is a schematic front view of a MEMS optical deflector.
FIG. 3 is a detailed view of a range from a center of a mirror portion to a movable frame in the MEMS optical deflector of FIG. 2.
FIG. 4A is an enlarged view of a range of 4A of FIG. 3.
FIG. 4B is an enlarged view of a range of 4B of FIG. 3.
FIG. 5 is a perspective view of a rigidity adjustment region.
FIG. 6A is an explanatory view when a voltage is applied to an intersection portion piezoelectric element.
FIG. 6B is an explanatory view when a voltage is applied to a coupling portion piezoelectric element.
FIG. 6C is an explanatory view when a voltage is applied to the intersection portion piezoelectric element and the coupling portion piezoelectric element.
FIG. 7 is a graph illustrating a relationship between a voltage application state of the intersection portion piezoelectric element and the coupling portion piezoelectric element, and a resonance frequency of a mirror portion around a resonance axis using a Young's modulus E of a substrate portion in the rigidity adjustment region as a parameter.
FIG. 8 is a configuration diagram of a control device of FIG. 1.

### Description of Embodiments

Hereinafter, embodiments of the present invention will be described. Needless to say, the present invention is not limited to the embodiments. Regarding common components, the same reference numerals are used throughout all the drawings.

### (Optical scanning device)

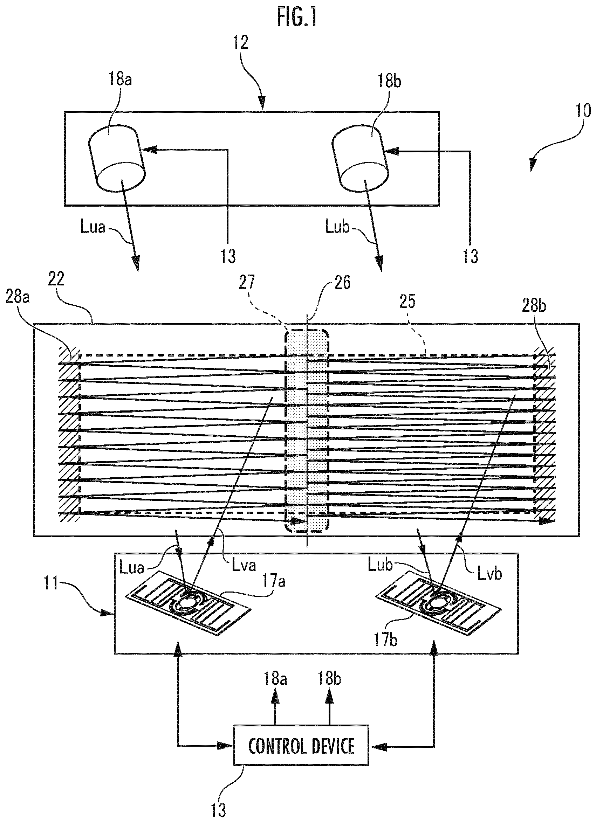

FIG. 1 is an overall schematic view of an optical scanning device 10. The optical scanning device 10 includes a MEMS device 11, a light source device 12, and a control device 13. The MEMS device 11 includes two MEMS optical deflectors 17a and 17b. The light source device 12 has two laser light sources 18a and 18b. The control device 13 controls the MEMS device 11 and the light source device 12.

A virtual screen 22 is defined for convenience in describing an operation of the optical scanning device 10. A light beam that is emitted from the optical scanning device 10 scans the virtual screen 22 and generates an image surface 25 on the virtual screen 22. The virtual screen 22 is disposed perpendicular to the light beam directed from the optical scanning device 10 to a center of the image surface 25. Vertical and horizontal of the image surface 25 are parallel to a scanning directions of the vertical and horizontal of the light beam emitted from the optical scanning device 10.

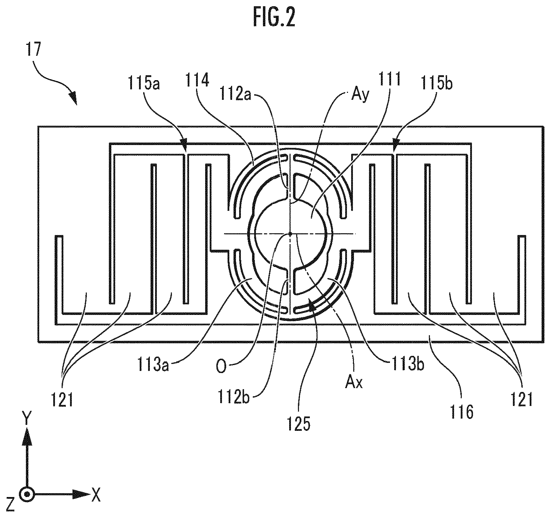

Light beams Lua and Lub from the laser light sources 18a and 18b are incident on centers of mirror portions 111 (FIG. 2) of the MEMS optical deflectors 17a and 17b, and reflected by the mirror portions 111 to become light beams Lva and Lvb, thereby being emitted from the MEMS device 11.

The light beams Lva and Lvb respective scan a left side and a right side of the image surface 25 of the virtual screen 22 with respect to a center line 26 of the image surface 25. The light beams Lva and Lvb scan between an upper side and a lower side of the image surface 25 in a vertical direction on the virtual screen 22.

When the laser light source 18a is always lit, the light beam Lva scans a range between a left end of an end range 28a and the center line 26 in a horizontal direction. When the laser light source 18b is always lit, the light beam Lvb scans a range between the center line 26 and a right end of an end range 28b in the horizontal direction. However, the end range 28a and the end range 28b are excluded from the image surface 25 as a scanning range outside the image surface 25. Typically, the control device 13 turns off the laser light sources 18a and 18b during a period when the light beams Lva and Lvb irradiate the end ranges 28a and 28b.

On the image surface 25 of FIG. 1, the number of scanning lines of the light beam Lva in the horizontal direction is less than the number of scanning lines of the light beam Lvb in the horizontal direction. The numbers means that the resonance frequency of the mirror portion 111 around a resonance axis Ay (FIG. 2) in the MEMS optical deflector 17a is lower than the resonance frequency of the mirror portion 111 around a resonance axis Ay (FIG. 2) in the MEMS optical deflector 17b. Originally, although the resonance frequency of any MEMS optical deflector 17 (general term for the MEMS optical deflectors 17a and 17b) has to be a predetermined setting value, such a difference occurs due to manufacturing variations.

When the MEMS optical deflector 17 independently generates the image of the image surface 25, even if the resonance frequency slightly deviates from the setting value, the image can be corrected by image processing of the control device 13, and thus the deterioration of the image quality can be suppressed. However, as illustrated in FIG. 1, the two MEMS optical deflectors 17 (general term for the MEMS optical deflectors 17a and 17b) are adjacent to each other in the center line 26 as a boundary line in the scanning direction (horizontal direction in FIG. 1) in the resonance direction, and the entire image is generated by being joined together, a difference in a scanning linear density in the center range 27 near the boundary line such as the center line 26 is conspicuous, and thus a user perceives the difference as a seam of the images. In order to avoid the problem, it is necessary to make adjustments so that the resonance frequencies among a plurality of MEMS optical deflectors 17 are equal.

In addition, in addition to the manufacturing variations, a temperature rise of the optical deflector itself due to an external environment such as temperature may cause the resonance frequency to exceed an allowable range in the specifications, and in that case, even an image produced by the single MEMS optical deflector 17 is not suitable for use.

### (MEMS optical deflector)

FIG. 2 is a schematic front view of the MEMS optical deflector 17. For convenience of the description of a configuration of the MEMS optical deflector 17, a three-axis coordinate system of an X-axis, a Y-axis, and a Z-axis that are orthogonal to each other is defined. An origin of the three-axis coordinate system is placed at a center O of the mirror portion 111. The X-axis and the Y-axis are aligned parallel to the horizontal and vertical directions of the MEMS optical deflector 17 which is rectangular when viewed in a front view. In addition, the Z-axis is aligned parallel to a direction of a plate thickness of the MEMS optical deflector 17 (thickness direction of SOI as a substrate).

The MEMS optical deflector 17 has a horizontally long rectangular shape when viewed in a front view, and is manufactured from an SOI (Silicon On Insulator) wafer. The MEMS optical deflector 17 includes torsion bars 112 (general term for upper and lower torsion bars 112a and 112b), inner actuators 113 (general term for left and right inner actuators 113a and 113b), a movable frame 114, outer actuators 115 (general term for left and right outer actuators 115a and 115b), and a fixed frame 116 in order from the mirror portion 111 of the center toward the outside.

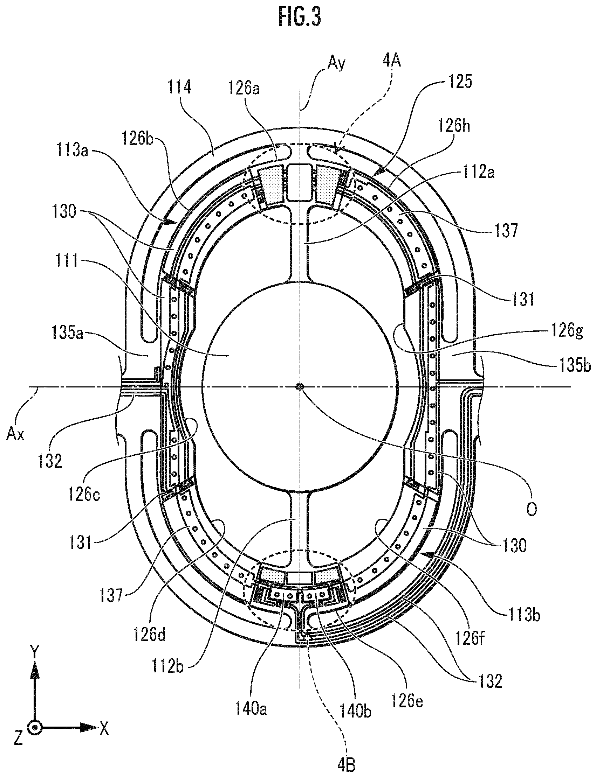

The light beams Lu (general term for the light beams Lua and Lub) from the laser light source 18 are incident on the circular mirror portion 111a at the center O. The inner actuators 113a and 113b are coupled to the torsion bar 112 from both sides to form an annular-shaped body 125 (FIG. 3) that surrounds the mirror portion 111 from the outside. The movable frame 114 forms another annular-shaped body that surrounds the annular-shaped body 125 from the outside. The torsion bars 112a and 112b extend from one end portion and the other end portion of the mirror portion 111 along the resonance axis Ay of the mirror portion 111, respectively, are coupled to the inner actuators 113a and 113b from both sides in a vertical direction to the resonance axis Ay at an intermediate portion, and are coupled to an inner periphery of the movable frame 114 at a tip thereof.

Each outer actuator 115 is formed with a plurality of cantilevers 121 in a meander array, and is interposed between the movable frame 114 and the fixed frame 116. Both the inner actuator 113 and the outer actuator 115 are piezoelectric actuators.

The mirror portion 111a reciprocally rotates in two axial directions of the resonance axis Ay and a non-resonance axis Ax, which are perpendicular to each other. The resonance axis Ay coincides with the center line of the torsion bar 112. When the mirror portion 111 faces the front, that is, when a normal line standing on the center O of the mirror portion 111 is parallel to the Z-axis, the resonance axis Ay and the non-resonance axis Ax overlap the Y-axis and the X-axis, respectively.

The reciprocating rotation of the mirror portion 111 around the resonance axis Ay utilizes the resonance of the mirror portion 111. In contrast, the reciprocating rotation of the mirror portion 111 around the non-resonance axis Ax is non-resonance. A reciprocating rotation frequency of the mirror portion 111 around the resonance axis Ay, that is, the resonance frequency is sufficiently higher than a non-resonance frequency of the mirror portion 111 around the non-resonance axis Ax.

### (Main portion of MEMS optical deflector)

FIG. 3 is a detailed view of a range from the center O of the mirror portion 111 to the movable frame 114 in the MEMS optical deflector 17 of FIG. 2. As described above, the left and right inner actuators 113a and 113b are coupled to each other at both ends thereof, and form the annular-shaped body 125 as a whole.

The annular-shaped body 125 intersects the mirror portion 111 at the intermediate portion of the mirror portion 111. The annular-shaped body 125 has eight compartment regions of compartment regions 126a, 126b, 126c, 126d, 126e, 126f, 126g, and 126h counterclockwise in order from the intersection portion of the torsion bar 112a and the inner actuator 113a when viewed in a front view of the MEMS optical deflector 17.

The compartment regions 126a and 126e include the intersection portions of the torsion bar 112 and the annular-shaped body 125, and straddle both of the inner actuators 113a and 113b. The compartment regions 126b to 126d belong to the inner actuator 113a, and the compartment regions 126f to 126h belong to the inner actuator 113b.

The compartment regions 126a and 126e are compartment regions where a rigidity changing piezoelectric element is formed. The compartment regions 126b to 126d and the compartment regions 126f to 126h are compartment regions where an actuator piezoelectric element 130 is formed. In the compartment region where the actuator piezoelectric element 130 is formed, portions adjacent to each other in a circumferential direction of the annular-shaped body 125 are separated by a slit 131.

All piezoelectric elements formed on the surface of the substrate include the actuator piezoelectric elements 130 and have a three-layer structure of an upper electrode layer, a piezoelectric film layer, and a lower electrode layer, in order from top to bottom. The slit 131 cuts at least the upper electrode layer and the piezoelectric film layer of the actuator piezoelectric element 130 in the adjacent compartment region.

The wiring 132 extends along the annular-shaped body 125 and is connected to the corresponding actuator piezoelectric element 130. Drive cycle voltages having opposite phases to each other are applied to the actuator piezoelectric elements 130 in the compartment regions 126b, 126d, and 126g, and the actuator piezoelectric elements 130 in the compartment regions 126c, 126f, and 126h, and thereby the torsion bar 112 is twisted in the same rotation direction around the resonance axis Ay by the inner actuators 113a and 113b on both sides in each reciprocating rotation cycle, and reciprocally rotates around the resonance axis Ay.

Coupling portions 135a and 135b in the X-axis direction extend a range on the non-resonance axis Ax between the end of the outer actuator 115 on a movable frame 114 side and the annular-shaped body 125, and support the movable frame 114 and the annular-shaped body 125 to an end of the outer actuator 115 on the movable frame 114 side. The movable frame 114 reciprocally rotates integrally with the end of the outer actuator 115 on the movable frame 114 side around the non-resonance axis Ax during the operation of the MEMS optical deflector 17. The outer actuator 115 is coupled to the fixed frame 116 at an end opposite to the movable frame 114. As a result, the torsion bar 112 is supported by the fixed frame 116 via the annular-shaped body 125 at the intermediate portion in the longitudinal direction thereof, and is supported by the fixed frame 116 via the movable frame 114 at the end on the opposite side of the mirror portion 111 in the longitudinal direction.

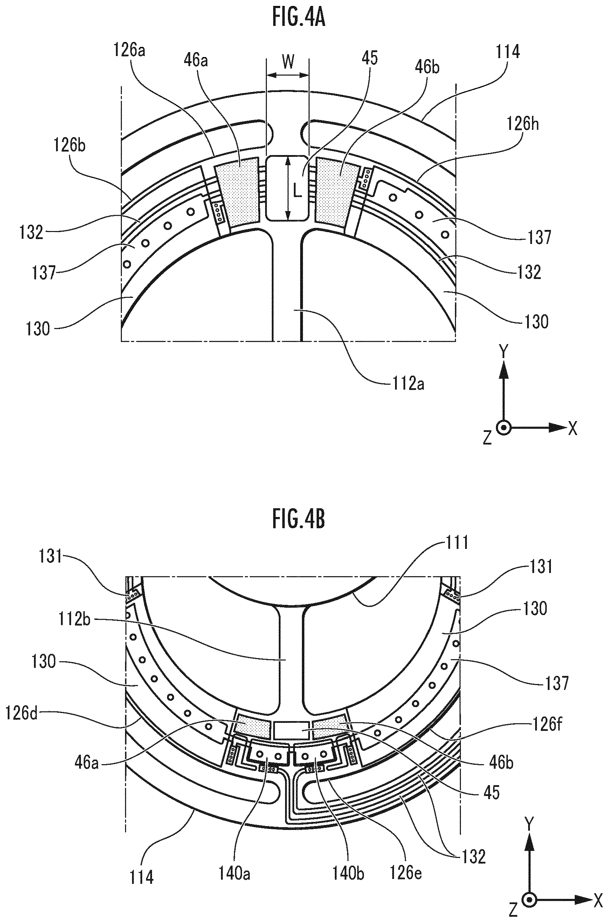

FIGS. 4A and 4B are enlarged views of ranges of 4A and 4B of FIG. 3, respectively. The ranges of 4A and 4B of FIG. 3 include the compartment regions 126a and 126e of the annular-shaped body 125 on the inside, respectively.

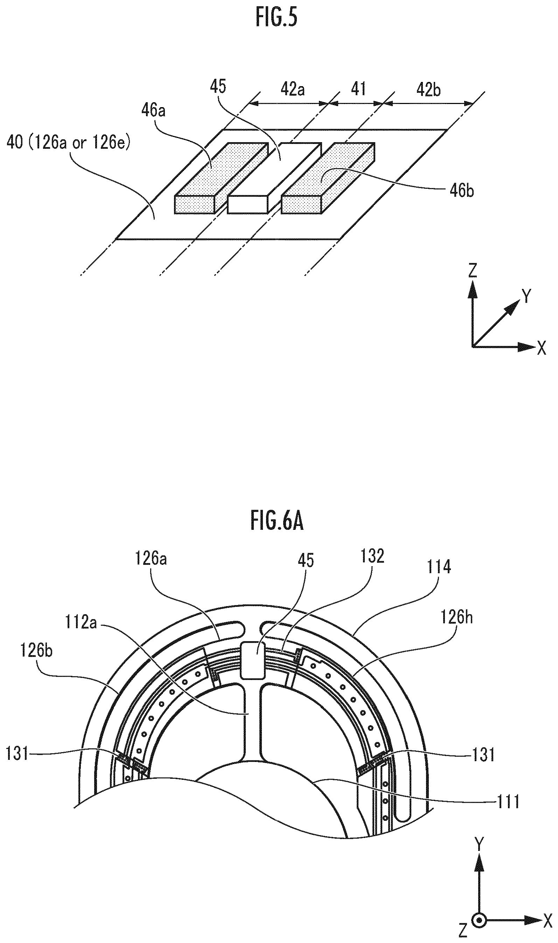

FIG. 5 is a perspective view of a rigidity adjustment region 40. The entire compartment region 126a is the rigidity adjustment region 40. In the compartment region 126e, only a half portion on the mirror portion 111 side in the direction of the resonance axis Ay is the rigidity adjustment region 40.

In the compartment region 126e, deflection angle sensors 140a and 140b are formed in the half portion of the compartment region 126e on the movable frame 114 side in the direction of the resonance axis Ay (FIG. 4B). The deflection angle sensors 140a and 140b are piezoelectric elements, and output voltages according to a torsion angle of the torsion bar 112b around the resonance axis Ay during operation of the MEMS optical deflector 17 and thus a rotation angle (deflection angle) of the mirror portion 111 around the resonance axis Ay.

The rigidity adjustment region 40 (FIG. 5) includes a center range region 41 that occupies a center range and end range regions 42a and 42b that occupy both end ranges on both sides thereof in the X-axis direction. The center range region 41 belongs to both the torsion bar 112 and the annular-shaped body 125 as the intersection portion of the torsion bar 112 and the annular-shaped body 125. The end range regions 42a and 42b belong only to the annular-shaped body 125.

The compartment region 126a of the annular-shaped body 125 intersects the torsion bar 112a in the center range region 41 in a vertical direction to the resonance axis Ay, and rotatably supports the torsion bar 112a around the resonance axis Ay in the center range region 41 as the intersection portion. As a result, the annular-shaped body 125 forms a one-side support that supports the torsion bar 112a. The compartment region 126e of the annular-shaped body 125 intersects the torsion bar 112b in the center range region 41 in the vertical direction to the resonance axis Ay, and rotatably supports the torsion bar 112b around the resonance axis Ay in the center range region 41 as the intersection portion. As a result, the annular-shaped body 125 forms the other-side support that supports the torsion bar 112b.

In FIG. 4A, W and L illustrate dimensions of the intersection portion piezoelectric element 45 in the X-axis and Y-axis directions, respectively. Since the L of the intersection portion piezoelectric element 45 is a dimension in a width direction of the annular-shaped body 125, it is possible to secure a dimension larger than the W of the intersection portion piezoelectric element 45.

As a voltage is applied to the intersection portion piezoelectric element 45, the W decreases while the L is maintained at an equal value. A decrease in the W means an increase in the rigidity of a portion where the intersection portion piezoelectric element 45 is formed (including an Si layer on the lower side) in the rigidity adjustment region 40.

Similarly, as the voltage of the coupling portion piezoelectric elements 46a and 46b is applied, the widths (dimensions in the X-axis direction) of the coupling portion piezoelectric elements 46a and 46b decrease. The decrease in the widths of the coupling portion piezoelectric elements 46a and 46b means an increase in the rigidity of the portion (including the Si layer on the lower side) where the coupling portion piezoelectric elements 46a and 46b are formed in the rigidity adjustment region 40.

### (Operation of main portion)

FIG. 6A is an explanatory view when a voltage is applied to the intersection portion piezoelectric element 45. As the voltage is applied to the intersection portion piezoelectric element 45 (specifically, the voltage is applied to the piezoelectric film layer of the intersection portion piezoelectric element 45 from the upper electrode and the lower electrode), the rigidity in the vicinity of the center range region 41 (including the Si layer) where the intersection portion piezoelectric element 45 is formed in the rigidity adjustment region 40 increases. As a result, the rigidity of the center range region 41 as the intersection portion in the torsion bar 112, and the resonance frequency of the mirror portion 111 around the resonance axis Ay increase.

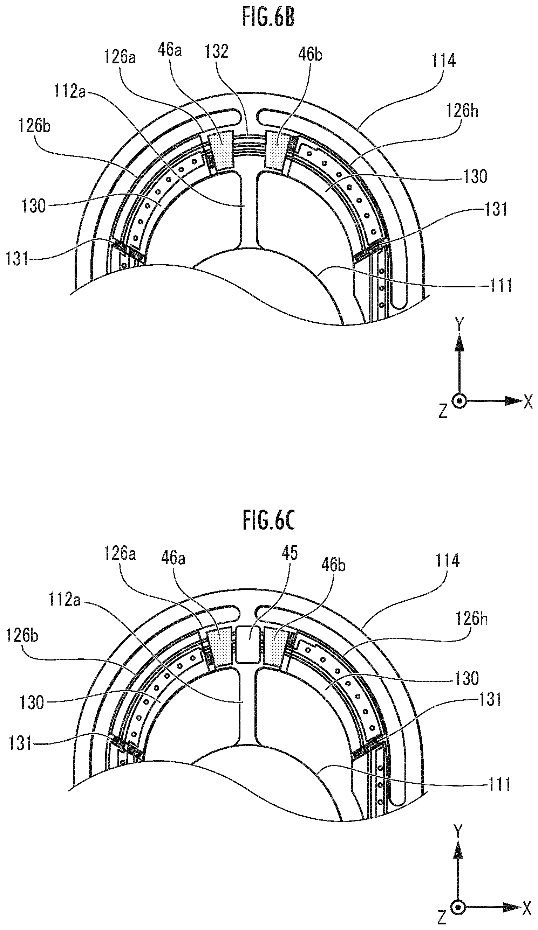

FIG. 6B is an explanatory view when a voltage is applied to the coupling portion piezoelectric elements 46a and 46b. As the voltage is applied to the coupling portion piezoelectric elements 46a and 46b, the rigidity in the vicinity of the end range regions 42a and 42b (including the Si layer) where the coupling portion piezoelectric elements 46a and 46b are formed in the rigidity adjustment region 40 increases. In other words, the rigidity in the vicinity of the coupling portions of the inner actuators 113a and 113b that are coupled to the center range region 41 of the torsion bar 112 from both sides in the vertical direction with respect to the resonance axis Ay to support the center range region 41 increases. As a result, the rigidity of the center range region 41 is also increased by being affected by the influences of the inner actuators 113a and 113b, and as a result, the rigidity of the substrate (Si layer) itself of the torsion bars 112a and 112b is slightly improved, and thus, the resonance frequency of the mirror portion 111 around the resonance axis Ay increases.

FIG. 6C is an explanatory view when a voltage is applied to the intersection portion piezoelectric element 45 and the coupling portion piezoelectric elements 46a and 46b. In this case, the rigidity of the substrate (Si layer) in the center range region 41 where the intersection portion piezoelectric element 45 and the coupling portion piezoelectric elements 46a and 46b are formed in the rigidity adjustment region 40 increases. As a result, the uniformity in the vicinity of the center range region 41 and the end range regions 42a and 42b is enhanced, and the resonance frequency of the mirror portion 111 around the resonance axis Ay increases.

### (Simulation)

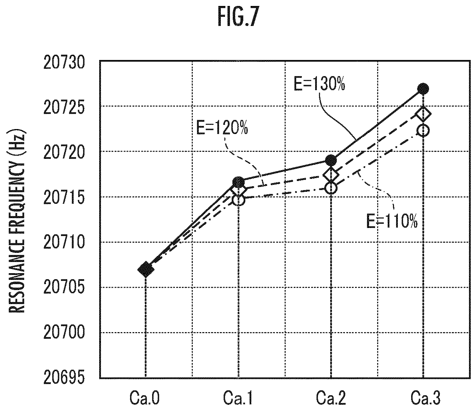

FIG. 7 is a graph illustrating a relationship between a voltage application state of the intersection portion piezoelectric element 45 and the coupling portion piezoelectric elements 46a and 46b, and the resonance frequency of the mirror portion 111 around the resonance axis Ay using a Young's modulus E of the substrate portion in the rigidity adjustment region 40 as a parameter. Characteristic values of the graph are calculated by using simulation software "IntelliSuite (registered trademark)" of Advanced Technology Co., Ltd.

In addition, a numerical value of each portion is as follows.
Diameter of the mirror portion 111: 1500 µm
Width of the torsion bar 112: 120 µm
Length of the torsion bar 112 (dimension between the mirror portion 111 and movable frame 114): 600 µm
Total area of the end range regions 42a and 42b: 50,000 square µm x 2
Area of the center range region 41: 37,000 square µm

Ca.0 to Ca.3 means as follows.
Ca.0: When all of the intersection portion piezoelectric element 45 and the coupling portion piezoelectric elements 46a and 46b are set to no applied voltage
Ca.1: When a voltage is applied only to the intersection portion piezoelectric element 45 (FIG. 6A)
Ca.2: When a voltage is applied to the coupling portion piezoelectric elements 46a and 46b (FIG. 6B)
Ca.3: When a voltage is applied to all of the intersection portion piezoelectric element 45 and the coupling portion piezoelectric elements 46a and 46b (FIG. 6C)

Further, the Young's modulus E of the substrate portion of the rigidity adjustment region 40 (Si layer of the device layer of the SOI is the substrate portion) was increased by 10% with respect to 100% of a reference, and the resonance frequency was examined at 110%, 120%, and 130%.

From FIG. 7, it can be seen that the resonance frequency increases in the order of Ca.0, Ca.1, Ca.2, and Ca.3. In addition, it can be seen that the higher the Young's modulus E of the substrate, the higher the resonance frequency is.

### (Control device)

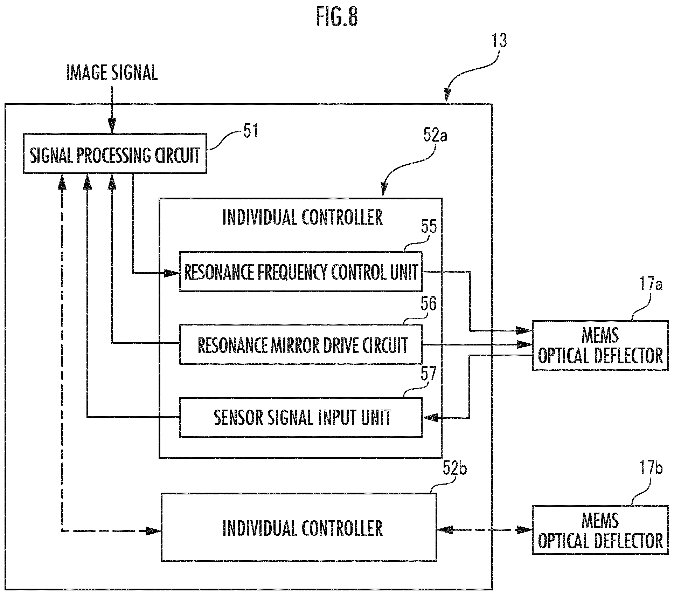

FIG. 8 is a configuration diagram of the control device 13 of FIG. 1. The control device 13 includes one signal processing circuit 51 and individual controllers 52a and 52b that are assigned to the MEMS optical deflectors 17a and 17b, respectively. The signal processing circuit 51 receives an image signal from an image source such as streaming or a storage device, and divides the image signal into a signal portion of the image portion generated by the light beam Lva of the MEMS optical deflector 17a and a signal portion of the image portion generated by the light beam Lvb of the MEMS optical deflector 17b to distribute the signal portions to the individual controllers 52a and 52b, respectively.

The individual controllers 52a and 52b have the same configuration. The individual controller 52 (general term for the individual controllers 52a and 52b) includes a resonance frequency control unit 55, a resonance mirror drive circuit 56, and a sensor signal input unit 57.

The sensor signal input unit 57 receives an output voltage of the deflection angle sensor 140 of the MEMS optical deflector 17 and outputs the output voltage to the signal processing circuit 51. The signal processing circuit 51 detects a rotation frequency around the resonance axis Ay in each MEMS optical deflector 17 based on an input from the sensor signal input unit 57 of each individual controller 52.

For this detection, for example, means is used in which driving is performed by changing a frequency in a state where the maximum voltage value of the drive waveform is constant, and a frequency having the largest deflection angle is determined as the rotation frequency, or the like. In addition, driving may be performed by changing the frequency in a state where the maximum voltage value of the drive waveform is constant, and a frequency larger than a predetermined deflection angle may be determined as a usable range as the rotation frequency. Such detection is performed, for example, at each timing when the MEMS optical deflector 17 is switched from OFF to ON.

The signal processing circuit 51 outputs the control signal to the resonance frequency control unit 55 and the resonance mirror drive circuit 56 of the individual controller 52 corresponding to the lower MEMS optical deflector 17, so that an indication rotation frequency Fi of the MEMS optical deflector 17 of the lower Fcl becomes equal to a detection rotation frequency Fch of the MEMS optical deflector 17 of the higher Fch (Fch > Fcl) in the detection rotation frequencies Fc around the resonance axis Ay in the MEMS optical deflectors 17a and 17b.

The control signal received from the signal processing circuit 51 by the resonance frequency control unit 55 is a signal related to the rigidity of the rigidity adjustment region 40. The control signal received from the signal processing circuit 51 by the resonance mirror drive circuit 56 is a signal related to the indication rotation frequency Fi (= Fch) of the mirror portion 111 around the resonance axis Ay in the MEMS optical deflector 17.

Each resonance mirror drive circuit 56 supplies a drive voltage having the indication rotation frequency Fi to the inner actuator 113 of the corresponding MEMS optical deflector 17. Further, the resonance frequency control unit 55, which receives the control signal of the rigidity change from the signal processing circuit 51, supplies a voltage that increases the rigidity of the rigidity adjustment region 40 of the corresponding MEMS optical deflector 17 to the intersection portion piezoelectric element 45 and/or the coupling portion piezoelectric element 46 of the rigidity adjustment region 40.

The signal processing circuit 51 uses, as a feedback signal, the output of the deflection angle sensor 140 in the MEMS optical deflector 17 in which is the voltage for changing the rigidity is output from the resonance frequency control unit 55, and performs feedback control to change the control signal to the resonance frequency control unit 55 until the rotation frequency around the resonance axis Ay in the MEMS optical deflector 17 becomes Fi (= Fch) based on the feedback signal.

In this manner, the rotation frequency around the resonance axis Ay in the MEMS optical deflectors 17a and 17b is aligned with Fch. The alignment means that a linear density of the light beam Lva of the MEMS optical deflector 17a in the vertical direction and a linear density of the light beam Lva of the MEMS optical deflector 17b in the vertical direction on the image surface 25 of FIG. 1 are aligned to a side with higher linear density. As a result, conspicuousness of the seam at the center line 26 of the image surface 25 is suppressed, and the image quality of the image surface 25 is improved.

### (Modified examples)

In the MEMS optical deflector 17, the inner actuator 113 has an annular-shaped body. In the present invention, the actuator that rotates the torsion bar around the rotation axis at the intersection portion may be a linear piezoelectric actuator. For example, each torsion bar is coupled to the linear piezoelectric actuator from both sides in a vertical direction with respect to the rotation axis at the intermediate portion in the longitudinal direction, and reciprocally rotates around the resonance axis Ay by the linear piezoelectric actuators on both sides.

In the MEMS optical deflector 17, the actuator is the piezoelectric type actuator. The actuator of the present invention may be an electrostatic type (example: Patent Literature 1) or an electromagnetic type.

In the MEMS optical deflector 17, the movable frame 114 is provided in addition to the inner actuator 113, and the inner actuator 113 is coupled to the intermediate portion in the longitudinal direction of the torsion bar 112. In the present invention, the movable frame 114 may be omitted, and the inner actuator 113 may be coupled to the end of the torsion bar 112 on the opposite side of the mirror portion 111.

In the MEMS optical deflector 17, the rigidity adjustment region 40 is provided with a total of three rigidity changing piezoelectric elements of the intersection portion piezoelectric element 45 and the coupling portion piezoelectric elements 46a and 46b. In the present invention, it is also possible to form a rigidity changing piezoelectric element in which the intersection portion piezoelectric element 45 and the coupling portion piezoelectric elements 46a and 46b are combined into one, and one of the intersection portion piezoelectric element 45 and the coupling portion piezoelectric elements 46a and 46b may be omitted.

In the MEMS optical deflector 17, in the compartment region 126e, the rigidity adjustment region 40 as the setting region where the rigidity changing piezoelectric element is formed and the setting region where the deflection angle sensor 140 is formed are on the mirror portion 111 side and the movable frame 114 side, respectively. In the present invention, the side of the rigidity adjustment region 40 and the side of the region where the deflection angle sensor 140 is formed may be reversed.

The MEMS optical deflector 17 is a two-axis type MEMS optical deflector that reciprocally rotates the mirror portion 111 around two rotation axes of the resonance axis Ay and the non-resonance axis Ax. The MEMS optical deflector of the present invention may be a one-axis type MEMS optical deflector having only one rotation axis of the mirror portion 111.

In the optical scanning device 10, the resonance frequency of the mirror portion 111 around the resonance axis Ay in the MEMS optical deflectors 17a and 17b was adjusted to the detection rotation frequency Fch that is higher side in the detection rotation frequency before the rigidity change of the rigidity adjustment region 40. In the optical scanning device of the present invention, the resonance frequency of the mirror portion 111 around the resonance axis Ay in the MEMS optical deflectors 17a and 17b can match the rotation frequency Fcs (Fcs > Fch) that is higher than the detection rotation frequency Fch in which the detection rotation frequency is high before rigidity change of the rigidity adjustment region 40. In that case, before the rigidity change of the rigidity adjustment region 40, the MEMS optical deflector 17 having the detection rotation frequency on the high side also applies a voltage to the intersection portion piezoelectric element 45 and/or the coupling portion piezoelectric elements 46a and 46b in the rigidity adjustment region 40 to increase the rigidity of the rigidity adjustment region 40.

In the MEMS optical deflector 17, the intersection portion piezoelectric element 45 and/or the coupling portion piezoelectric elements 46a and 46b were operated in two ways of when no voltage was applied and when a voltage was applied. In the present invention, when a voltage is applied to the intersection portion piezoelectric element 45 and/or the coupling portion piezoelectric elements 46a and 46b, the applied voltage is changed in a plurality of steps or continuously, so that the rigidity of the rigidity adjustment region 40 can be changed in a plurality of steps or continuously.

In the MEMS optical deflector 17, the one-side torsion bar and the other-side torsion bar are described as the torsion bars 112a and 112b, respectively. In the present invention, the one-side torsion bar and the other-side torsion bar may be reversed.

In the MEMS optical deflector 17, the one-side intersection portion and the other-side intersection portion are described as the center range region 41 of the compartment regions 126a and 126e, respectively. In the MEMS optical deflector of the present invention, the one-side intersection portion and the other-side intersection portion may be reversed.

In the MEMS optical deflector 17, the one-side support and the other-side support are described as a half portion on the torsion bar 112a side and a half portion on the torsion bar 112b side of the annular-shaped body 125, respectively. The one-side support and the other-side support of the present invention may be reversed.

In the MEMS device 11, the MEMS optical deflectors 17a and 17b are respectively described as the first optical deflector and the second optical deflector. In the present invention, the MEMS optical deflectors 17a and 17b may be the second optical deflector and the first optical deflector, respectively.
42 ... end range region
45 ... intersection portion piezoelectric element
46 ... coupling portion piezoelectric element
111 ... mirror portion
112a, 112b ... torsion bar
113 ... inner actuator
114 ... movable frame
125 ... annular-shaped body
126a to 126h ... compartment region
130 ... actuator piezoelectric element
140 ... deflection angle sensor.

## Claims

1. A MEMS optical deflector (17, 17a, 17b) comprising:
a mirror portion (111) configured to reflect a light beam;
a one-side torsion bar (112a) and the other-side torsion bar (112b) extending from one end portion and the other end portion of the mirror portion (111) along a rotation axis (Ay) of the mirror portion (111), respectively;
a one-side support (125) and the other-side support (125) configured to intersect the one-side torsion bar (112a) and the other-side torsion bar (112b) in a one-side intersection portion (126a) and the other-side intersection portion (126e) in a vertical direction with respect to the rotation axis (Ay), respectively, and rotatably support the one-side torsion bar (112a) and the other-side torsion bar (112b) around the rotation axis (Ay) in the one-side intersection portion (126a) and the other-side intersection portion (126e), respectively;
actuators (113, 113a, 113b; 115, 115a, 115b) configured to rotate the one-side torsion bar (112a) and the other-side torsion bar (112b) around the rotation axis (Ay) in the one-side intersection portion (126a) and the other-side intersection portion (126e), respectively; and
a rigidity changing piezoelectric element (45, 46a, 46b) formed in at least one setting region (40) of a one-side setting region and the other-side setting region including at least a part of the one-side intersection portion (126a) and the other-side intersection portion (126e) in the vertical direction in the one-side torsion bar (112a) and the other-side torsion bar (112b) in a center range (41), respectively to change a rigidity of the one setting region (40) when a voltage is applied;
wherein each of the one-side setting region (40) and the other-side setting region (40) is set as a region including the center range (41) and both end ranges (42a, 42b) on both sides of the center range (41) in the vertical direction, and
wherein the rigidity changing piezoelectric element (45, 46a, 46b) is formed in at least one of the center range (41) and the both end ranges (42a, 42b);
**characterized in that**
the rigidity changing piezoelectric element (45, 46a, 46b) includes a first rigidity changing piezoelectric element (45) formed in the center range (41) and a second rigidity changing piezoelectric element (46a, 46b) formed in the both end ranges (42a, 42b), and
a rigidity of the one setting region (40) is different between when the voltage is applied only to the first rigidity changing piezoelectric element (45), when the voltage is applied only to the second rigidity changing piezoelectric element (46a, 46b), and when the voltage is applied to both the first rigidity changing piezoelectric element (45) and the second rigidity changing piezoelectric element (46a, 46b).

2. The MEMS optical deflector according to claim 1, wherein
the other-side support (125) has a sensor setting region on a mirror portion side or an opposite side of the mirror portion side in an extending direction of the rotation axis (Ay) with respect to the both end ranges (42a, 42b) of the other-side setting region, and
a piezoelectric sensor (140a, 140b) configured to detect a rotation angle of the mirror portion (111) around the rotation axis (Ay) is formed in the sensor setting region.

3. The MEMS optical deflector according to any one of claims 1or 2, wherein
the one-side support (125) and the other-side support (125) form one annular-shaped body (125) that surrounds the mirror portion (111) from an outside, and
the actuators (113, 113a, 113b; 115, 115a, 115b) are piezoelectric actuators formed in the annular-shaped body (125).

4. The MEMS optical deflector according to claim 3, further comprising:
an annular movable frame body (114) that surrounds the annular-shaped body (125) from the outside,
wherein the movable frame body (114) is coupled to and supported by each torsion bar (112a, 112b) on the rotation axis (Ay), and is coupled to and supported by the annular-shaped body (125) on another rotation axis(Ax) of the mirror portion (111).

5. An optical scanning device (10) comprising:
the MEMS optical deflector (17, 17a, 17b) according to any one of claims 1 to 4;
a frequency detector (51) configured to detect a reciprocating rotation frequency of the mirror portion (111) around the rotation axis (Ay); and
a control unit (52, 52a, 52b) configured to control the applied voltage of the rigidity changing piezoelectric element (45, 46a, 46b) based on an output of the frequency detector (51).

6. The optical scanning device according to claim 5, wherein
the MEMS optical deflector (17, 17a, 17b) includes a first MEMS optical deflector (17a) and a second MEMS optical deflector (17b) in which scanning regions of a light beam (Lva, Lvb) overlap each other in a one-side end region (27), and
the control unit (52, 52a, 52b) is configured to compare resonance frequencies of the mirror portion (111) around the rotation axis (Ay) when no voltage is applied to the rigidity changing piezoelectric elements (45, 46a, 46b) of the first MEMS optical deflector (17a) and the second MEMS optical deflector (17b), and to control the application of the voltage of the rigidity changing piezoelectric element (45, 46a, 46b) of the MEMS optical deflector (17) with a lower resonance frequency such that a resonance frequency of the MEMS optical deflector with a lower resonance frequency matches a resonance frequency of the MEMS optical deflector with a higher resonance frequency.

## Patentansprüche

1. MEMS-Optikdeflektor (17, 17a, 17b), der Folgendes aufweist:
einen Spiegelteil (111), der zur Reflektion eines Lichtstrahls konfiguriert ist;
eine Torsionsstange (112a) der einen Seite und eine Torsionsstange (112b) der anderen Seite, wobei diese sich entsprechend von einen Endteil und vom anderen Endteil des Spiegelteils (111) entlang einer Rotationsachse (Ay) des Spiegelteils (111) erstrecken;
einen Träger (125) der einen Seite und einen Träger (125) der anderen Seite, die so konfiguriert sind, dass sie die Torsionsstange (112a) der einen Seite und die Torsionsstange (112b) der anderen Seite an einem entsprechenden Schnittteil (126a) der einen Seite und einem Schnittteil (126e) der anderen Seite in einer vertikalen Richtung bezüglich der Rotationsachse (Ay) schneiden, und die drehbar die entsprechende Torsionsstange (112a) der einen Seite und die Torsionsstange (112b) der anderen Seite um die Rotationsachse (Ay) an dem entsprechenden Schnittteil (126a) der einen Seite und dem Schnittteil (126e) der anderen Seite tragen;
Betätigungsvorrichtungen (113, 113a, 113b; 115, 115a, 115b), die so konfiguriert sind, dass sie die Torsionsstange (112a) der einen Seite und die Torsionsstange (112b) der anderen Seite um die Rotationsachse (Ay) an dem entsprechenden Schnittteil (112a) der einen Seite und dem Schnittteil (126e) der anderen Seite drehen; und
ein bezüglich der Steifigkeit veränderliches piezoelektrisches Element (45, 46a, 46b), das in mindestens einer Einstellungsregion (40) einer Einstellungsregion der einen Seite und einer Einstellungsregion der anderen Seite geformt ist, welche zumindest einen Teil des Schnittteils (126a) der einen Seite und des Schnittteils (126e) der anderen Seite in der vertikalen Richtung in der entsprechenden Torsionsstange (112a) der einen Seite und der Torsionsstange (112b) der anderen Seite in einem mittleren Bereich (41) aufweisen, um eine Steifigkeit der einen Einstellungsregion (40) zu verändern, wenn eine Spannung angelegt wird;
wobei jede der Einstellungsregion (40) der einen Seite und der Einstellungsregion (40) der anderen Seite als eine Region festgelegt ist, welche den mittleren Bereich (41) und beide Endbereiche (42a, 42b) an beiden Seiten des mittleren Bereiches (41) in der vertikalen Richtung aufweisen, und
wobei das bezüglich der Steifigkeit veränderliche piezoelektrische Element (45, 46a, 46b) in zumindest einem des mittleren Bereiches (41) und der beiden Endbereiche (42a, 42b) geformt ist;
**dadurch gekennzeichnet, dass**
das bezüglich der Steifigkeit veränderliche piezoelektrische Element (45, 46a, 46b) ein erstes bezüglich der Steifigkeit veränderliches piezoelektrisches Element (45) aufweist, das in dem mittleren Bereich (41) geformt ist, und ein zweites bezüglich der Steifigkeit veränderliches piezoelektrisches Element (46a, 46b), das in den beiden Endbereichen (42a, 42b) geformt ist, und
eine Steifigkeit der einen Einstellungsregion (40) unterschiedlich zwischen den Fällen ist, wenn die Spannung nur an dem ersten bezüglich der Steifigkeit veränderlichen piezoelektrischen Element (45) angelegt ist, wenn die Spannung nur an dem zweiten bezüglich der Steifigkeit veränderlichen piezoelektrischen Element (46a, 46b) angelegt ist, und wenn eine Spannung an sowohl dem ersten bezüglich der Steifigkeit veränderlichen piezoelektrischen Element (45) als auch an dem zweiten bezüglich der Steifigkeit veränderlichen piezoelektrischen Element (46a, 46b) angelegt ist.

2. MEMS-Optikdeflektor nach Anspruch 1, wobei der Träger (125) der anderen Seite eine Sensoreinstellungsregion an einer Seite des Spiegelteils oder an einer Seite gegenüberliegend zur Seite des Spiegelteils, und zwar in einer Verlaufsrichtung der Rotationsachse (Ay) bezüglich der beiden Endbereiche (42a, 42b) des Einstellungsbereiches der anderen Seite hat, und
wobei ein piezoelektrischer Sensor (140a, 140b), der zur Detektion eines Rotationswinkels des Spiegelteils (111) um die Rotationsachse (Ay) konfiguriert ist, in der Sensoreinstellungsregion geformt ist.

3. MEMS-Optikdeflektor nach einem der Ansprüche 1 oder 2, wobei
der Träger (125) der einen Seite und der Träger (125) der anderen Seite einen ringförmigen Körper (125) formen, der den Spiegelteil (111) von außen umgibt, und
wobei die Betätigungsvorrichtungen (113, 113a; 113b,115, 115a; 115b) piezoelektrische Betätigungsvorrichtungen sind, die in dem ringförmigen Körper (125) geformt sind.

4. MEMS-Optikdeflektor nach Anspruch 3, der weiter Folgendes aufweist:
einen ringförmigen bewegbaren Rahmenkörper (114), der den ringförmigen Körper (125) von außen umgibt,
wobei der bewegbare Rahmenkörper (114) mit jeder Torsionsstange (112a, 112b) an der Rotationsachse (Ay) gekoppelt ist und von diesen getragen wird, und mit dem ringförmigen Körper (125) an der anderen Rotationsachse (Ax) des Spiegelteils (111) gekoppelt ist und von diesem getragen wird.

5. Optische Scanvorrichtung (10), die Folgendes aufweist:
den MEMS-Optikdeflektor (17, 17a, 17b) nach einem der Ansprüche 1 bis 4;
einen Frequenzdetektor (51), der konfiguriert ist, um eine Hin- und Her-Rotationsfrequenz des Spiegelteils (111) um die Rotationsachse (Ay) zu detektieren; und
eine Steuereinheit (52, 52a, 52b), die konfiguriert ist, um die angelegte Spannung des bezüglich der Steifigkeit veränderlichen piezoelektrischen Elementes (45, 46a, 46b) basierend auf einer Ausgabe des Frequenzdetektors (51) zu steuern.

6. Optische Scanvorrichtung nach Anspruch 5, wobei
der MEMS-Optikdeflektor (17, 17a, 17b) einen ersten MEMS-Optikdeflektor (17a) und einen zweiten MEMS-Optikdeflektor (17b) aufweist, wobei sich die Scanregionen eines Lichtstrahls (Lva, Lvb) in einem Endbereich (27) der einen Seite überlappen, und
wobei die Steuereinheit (52, 52a, 52b) konfiguriert ist, um Resonanzfrequenzen des Spiegelteils um die Rotationsachse (Ay) zu vergleichen, wenn keine Spannung an die bezüglich der Steifigkeit veränderlichen piezoelektrischen Elemente (45, 46a, 46b) des ersten MEMS-Optikdeflektor (17a) und des zweiten MEMS-Optikdeflektors (17b) angelegt ist, und um das Anlegen der Spannung des bezüglich der Steifigkeit veränderlichen piezoelektrischen Elementes (45, 46a, 46b) des MEMS-Optikdeflektors (17) mit einer geringeren Resonanzfrequenz so zu steuern, dass eine Resonanzfrequenz des MEMS-Optikdeflektors mit einer geringeren Resonanzfrequenz zu einer Resonanzfrequenz des MEMS-Optikdeflektors mit einer höheren Resonanzfrequenz passt.

## Revendications

1. Déflecteur optique MEMS (17, 17a, 17b) comprenant :
une portion miroir (111) configurée pour réfléchir un faisceau lumineux ;
une barre de torsion d'un premier côté (112a) et une barre de torsion d'un autre côté (112b) s'étendant respectivement à partir d'une première extrémité à partir et de l'autre extrémité de la portion miroir (111) le long d'un axe de rotation (Ay) de la portion miroir (111) ;
un support du premier côté (125) et un support de l'autre côté (125) configurés pour croiser la barre de torsion du premier côté (112a) et la barre de torsion de l'autre côté (112b) respectivement dans une portion d'intersection du premier côté (126a) et dans une portion d'intersection de l'autre côté (126e) dans une direction verticale par rapport à l'axe de rotation (Ay), et pour supporter à rotation la barre de torsion du premier côté (112a) et la barre de torsion de l'autre côté (112b) autour de l'axe de rotation (Ay) respectivement dans la portion d'intersection du premier côté (126a) et dans la portion d'intersection de l'autre côté (126e) ;
des actionneurs (113, 113a, 113b ; 115, 115a, 115b) configurés pour faire tourner la barre de torsion du premier côté (112a) et la barre de torsion de l'autre côté (112b) autour de l'axe de rotation (Ay), respectivement dans la portion d'intersection du premier côté (126a) et dans la portion d'intersection de l'autre côté (126e) ; et
un élément piézoélectrique à rigidité variable (45, 46a, 46b) formé dans au moins une première région de réglage (40) d'une région de réglage du premier côté et une région de réglage de l'autre côté comportant au moins une partie de la portion d'intersection du premier côté (126a) et de la portion d'intersection de l'autre côté (126e) dans la direction verticale (Ay) respectivement dans la barre de torsion du premier côté (112a) et dans la barre de torsion de l'autre côté (112b) dans une plage centrale (41) pour modifier la rigidité de la première région de réglage (40) lorsqu'une tension est appliquée ;
dans lequel chacune parmi la région de réglage du premier côté (40) et la région de réglage de l'autre côté (40) est définie comme étant une région comportant la plage centrale (41) et les deux plages d'extrémité (42a, 42b) de part et d'autre de la plage centrale (41) dans la direction verticale, et
dans lequel l'élément piézoélectrique à rigidité variable (45, 46a, 46b) est formé dans au moins une parmi la plage centrale (41) et les deux plages d'extrémité (42a, 42b) ;
**caractérisé en ce que**
l'élément piézoélectrique à rigidité variable (45, 46a, 46b) comporte un premier élément piézoélectrique à rigidité variable (45) formé dans la plage centrale (41) et un deuxième élément piézoélectrique à rigidité variable (46a, 46b) formé dans les deux plages d'extrémité (42a, 42b), et
une rigidité de la première région de réglage (40) est différente selon que la tension est appliquée uniquement au premier élément piézoélectrique à rigidité variable (45), que la tension est appliquée uniquement au deuxième élément piézoélectrique à rigidité variable (46a, 46b), ou que la tension est appliquée à la fois au premier élément piézoélectrique à rigidité variable (45) et au deuxième élément piézoélectrique à rigidité variable (46a, 46b).

2. Déflecteur optique MEMS selon la revendication 1, dans lequel
le support de l'autre côté (125) a une région de réglage du capteur sur un côté de la portion miroir ou sur un côté opposé du côté de la portion miroir, dans une direction d'extension de l'axe de rotation (Ay) par rapport aux deux plages d'extrémité (42a, 42b) de la région de réglage de l'autre côté, et
un capteur piézoélectrique (140a, 140b) configuré pour détecter un angle de rotation de la portion miroir (111) autour de l'axe de rotation (Ay) est formé dans la région de réglage du capteur.

3. Déflecteur optique MEMS selon l'une quelconque des revendications 1 ou 2, dans lequel
Le support du premier côté (125) et le support de l'autre côté (125) forment un premier corps en forme d'anneau (125) qui entoure de l'extérieur la portion miroir (111), et
les actionneurs (113, 113a, 113b ; 115, 115a, 115b) sont des actionneurs piézoélectriques formés dans le corps en forme d'anneau (125).

4. déflecteur optique MEMS selon la revendication 3, comprenant en outre :
un corps de cadre annulaire mobile (114) qui entoure de l'extérieur le corps en forme d'anneau (125),
dans lequel le corps de cadre mobile (114) est relié et supporté par chaque barre de torsion (112a, 112b) sur l'axe de rotation (Ay), et est relié et supporté par le corps en forme d'anneau (125) sur un autre axe de rotation (Ax) de la portion miroir (111).

5. Dispositif de balayage optique comprenant :
le déflecteur optique MEMS (17, 17a, 17b) selon l'une quelconque des revendications 1 à 4 ;
un détecteur de fréquence (51) configuré pour détecter une fréquence de rotation en va-et-vient de la portion miroir (111) autour de l'axe de rotation (Ay) ; et
une unité de commande (52, 52a, 52b) configurée pour commander la tension appliquée à l'élément piézoélectrique à rigidité variable (45, 46a, 46b) sur la base d'une sortie du détecteur de fréquence (51).

6. dispositif de balayage optique selon la revendication 5, dans lequel
Le déflecteur optique MEMS (17, 17a, 17b) comporte un premier déflecteur optique MEMS (17a) et un deuxième déflecteur optique MEMS (17b) dans lequel des régions de balayage d'un faisceau lumineux (Lva, Lvb) se chevauchent l'une l'autre dans une région d'extrémité d'un premier côté (27), et
l'unité de commande (52, 52a, 52b) est configurée pour comparer des fréquences de résonance de la portion miroir (111) autour de l'axe de rotation (Ay) lorsqu'aucune tension n'est appliquée aux éléments piézoélectriques à rigidité variable (45, 46a, 46b) du premier déflecteur optique MEMS (17a) et du deuxième déflecteur optique MEMS (17b), et pour commander l'application de la tension à l'élément piézoélectrique à rigidité variable (45, 46a, 46b) du déflecteur optique MEMS (17) à une fréquence de résonance inférieure, de sorte que la fréquence de résonance du déflecteur optique MEMS d'une fréquence de résonance inférieure corresponde à la fréquence de résonance du déflecteur optique MEMS ayant une fréquence de résonance supérieure.
